(19) Europäisches Patentamt
European Patent Office
Office européen des brevets

(11) **EP 4 346 105 B1**

(12) **EUROPEAN PATENT SPECIFICATION**

(45) Date of publication and mention
of the grant of the patent:
**26.11.2025  Bulletin 2025/48**

(21) Application number: **23157511.9**

(22) Date of filing: **20.02.2023**

(51) International Patent Classification (IPC):
*H03L 7/087* (2006.01)  *H03L 7/089* (2006.01)
*H03L 7/093* (2006.01)  *H03L 7/18* (2006.01)

(52) Cooperative Patent Classification (CPC):
**H03L 7/087; H03L 7/0891; H03L 7/093; H03L 7/18**

(54) **PHASE DIFFERENCE CONTROL CIRCUIT**

PHASENDIFFERENZ-REGELKREIS

CIRCUIT DE COMMANDE DE DIFFÉRENCE DE PHASE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **30.09.2022  KR 20220125491**

(43) Date of publication of application:
**03.04.2024  Bulletin 2024/14**

(73) Proprietors:
• **SKAIChips Co., Ltd.
Gyeonggi-do 16419 (KR)**
• **Research & Business Foundation
Sungkyunkwan
University
Gyeonggi-do 16419 (KR)**

(72) Inventors:
• **Lee, Kang Yoon
05834 Seoul (KR)**
• **Huh, Hyung Ki
06190 Seoul (KR)**
• **Jo, Jong Wan
16417 Suwon-si, Gyeonggi-do (KR)**
• **Kim, Ho Won
16361 Suwon-si, Gyeonggi-do (KR)**

(74) Representative: **Grünecker Patent- und
Rechtsanwälte
PartG mbB
Leopoldstraße 4
80802 München (DE)**

(56) References cited:
**US-A1- 2001 007 436    US-A1- 2011 012 683
US-B1- 6 317 476**

• **AXHOLT ANDREAS ET AL: "A 60 GHz receiver
front-end with PLL based phase controlled LO
generation for phased-arrays", ANALOG
INTEGRATED CIRCUITS AND SIGNAL
PROCESSING, SPRINGER NEW YORK LLC, US,
vol. 80, no. 1, 29 April 2014 (2014-04-29), pages
23 - 32, XP035317598, ISSN: 0925-1030,
[retrieved on 20140429], DOI: 10.1007/
S10470-014-0301-5**
• **AXHOLT A ET AL: "A PLL based 12GHz LO
generator with digital phase control in 90nm
CMOS", MICROWAVE CONFERENCE, 2009.
APMC 2009. ASIA PACIFIC, IEEE, PISCATAWAY,
NJ, USA, 7 December 2009 (2009-12-07), pages
289 - 292, XP031614191, ISBN: 978-1-4244-2801-4**

**Description**

## BACKGROUND

**1. Field**

A technology related to a circuit which generates a clock having a selected phase difference with respect to a reference clock is disclosed.

**2. Description of Related Art**

A radio frequency (RF) phase shifter technology which controls a phase difference for beamforming transmission is known. An analog phase shift circuit using a transmission line having a length corresponding to a phase difference to be adjusted has large loss and has a limitation in terms of frequency band or phase control. Further, for example, in a field such as wireless power transmission technology that transmits power to a selected target using beamforming technology, precision of phase shifting is required, but it is difficult to satisfy this condition by such analog-based technology.

AXHOLT ANDREAS ET AL: "A 60 GHz receiver front-end with PLL based phase controlled LO generation for phased-arrays", Analog Integrated Circuits And Signal Processing, Springer New York LLC, US, 29 April 2014 pages 23-32, XP035317598 discloses a front-end architecture for fully integrated 60 GHz phased array receivers. AXHOLT ET AL employs LO-path beamforming using a phase controlled phase-locked loop (PC-PLL). To demonstrate the architecture a circuit is implemented featuring a two stage low noise amplifier, two cascaded active mixers, and a PC-PLL.

AXHOLT A ET AL: "A PLL based 12GHz LO generator with digital phase control in 90nm CMOS", Microwave Conference, 2009. APMC 2009. Asia Pacific, IEEE, Piscataway, NJ, USA 7 December 2009, pages 289-292, XP031614191 discloses a 12 GHz phase-locked loop (PLL) with digital output phase control implemented in a 90 nm CMOS process. It is intended for LO signal generation in integrated phased array transceivers. Locally placed PLLs eliminate the need of long high frequency LO routing to each transceiver in a phased array circuit. Routing losses are thereby reduced and design of integrated phased array transceivers become more modular.

US 6,317,476 B1 describes a device for suppressing spurious signals generated by a fractional-N synthesizer. The fractional-N synthesizer generates an output frequency where an underlying PLL circuit uses a frequency divider for dividing the output frequency by a frequency-division ratio to obtain a comparison frequency and performs phase-comparison operations between a reference frequency and the comparison frequency to control the output frequency. The output frequency is changed by a frequency interval smaller than the reference frequency by making a temporal change to the frequency division ratio once in every predetermined number of cycles.

US 2011/012683 A1 discloses a phase lock loop comprising: a first phase detector configured to receive a first clock and a second clock and output a first detector output signal; a second phase detector configured to receive the first clock and the second clock and output a second detector output signal; a summing circuit to sum the first detector output signal and the second detector output signal into a control signal; a loop filter to filter the control signal into a refined control signal; and a controllable oscillator to generate the output clock in accordance with a control by the refined control signal.

2001/007436 A1 describes a frequency detector and a phase-locked loop circuit including the frequency detector.

## SUMMARY

The present disclosure is directed to realizing a phase shifting function by modifying a phase locked loop among existing circuits without separately adding a radio frequency (RF) phase shifter.

Further, the present disclosure is directed to increasing the resolution of phase shift adjustment.

Further, the present disclosure is directed to decreasing errors in phase shifting adjustment.

These objects are achieved by the phase shift circuits according to independent claims 1 and 8.

Preferred embodiments are defined in the dependent claims.

## BRIEF DESCRIPTION OF THE DRAWINGS

FIG. 1 is a block diagram illustrating a configuration of a phase shift circuit according to one embodiment.
FIG. 2 is an exemplary timing diagram between internal signals of the circuit in FIG. 1.
FIG. 3 is a block diagram illustrating a configuration of a phase shift circuit according to another embodiment.
FIG. 4 illustrates one embodiment of a charge/discharge circuit of a charge pump.

FIG. 5 is an exemplary timing diagram between internal signals of the circuit in FIG. 3.

FIG. 6 is a block diagram illustrating a configuration of a phase shift circuit according to still another embodiment.

FIG. 7 is an exemplary timing diagram between internal signals of the circuit in FIG. 6.

FIG. 8 is a block diagram illustrating a configuration of a phase shift circuit according to yet another embodiment.

FIG. 9 is a block diagram illustrating a configuration of a phase shift circuit according to yet another embodiment.

Throughout the drawings and the detailed description, unless otherwise described, the same drawing reference numerals will be understood to refer to the same elements, features, and structures. The relative size and depiction of these elements may be exaggerated for clarity, illustration, and convenience.

## DETAILED DESCRIPTION

The above-described and additional aspects are embodied through the embodiments described with reference to the accompanying drawings. It is understood that the components of each embodiment may be variously combined within one embodiment or with components of another embodiment unless otherwise mentioned or contradicted by each other.

Hereinafter, preferable embodiments of the present disclosure will be described in detail with reference to the accompanying drawings.

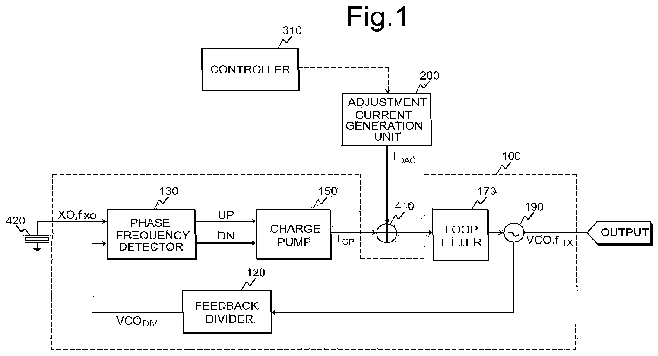

< Description of embodiment in FIG. 1>

According to one aspect of the present disclosure, internal phase shifting is configured by adding a phase adjustment current to a loop current of a phase locked loop circuit of a wireless transmission terminal having a multi-array antenna. FIG. 1 is a block diagram illustrating a configuration of a phase shift circuit according to one embodiment to which this aspect is applied. As shown in the drawing, the phase shift circuit according to one embodiment includes a phase locked loop circuit 100 and an adder circuit 410. The phase locked loop circuit 100 may be one of various types of generally known phase locked loop circuits. According to one aspect, the phase-locked loop circuit includes a feedback divider 120 in a feedback loop.

The adder circuit 410 adds the phase adjustment current to the loop current of the phase locked loop circuit 100. The adder circuit 410 may be implemented as an analog adder circuit when the phase locked loop circuit 100 is implemented as an analog circuit. As another example, when the phase locked loop circuit 100 is implemented as a digital circuit, the adder circuit 410 may be implemented as a digital adder circuit.

An output frequency of the phase locked loop circuit 100 fluctuates as much as the phase adjustment current added by the adder circuit. A phase frequency detector 130 maintains a constant phase difference between two inputs in a stable state due to the phase adjustment current although the phase difference between the two inputs should be originally 0 through a feedback divider 120. According to one aspect, since the phase adjustment current is applied to the adder circuit 410, this phase difference is maintained even when the feedback loop is in a stable state, and accordingly, an output of a voltage-controlled oscillator 190 or the feedback divider 120 has a phase difference with respect to a reference frequency as intended by the phase adjustment current applied to the adder circuit. The output of the voltage-controlled oscillator 190 may be transmitted to an antenna as a transmission signal of a wireless power transmission circuit through a power amplifier.

< Description of embodiment in FIG. 1>

In the illustrated embodiment, the phase locked loop circuit may include the phase frequency detector (PFD) 130, a charge pump 150, a loop filter 170, and the voltage-controlled oscillator 190. The phase frequency detector 130 compares a phase difference between a reference clock output from a reference clock generation unit 420 and a feedback signal fed back from the voltage-controlled oscillator 190 to output a comparison signal. In the illustrated embodiment, the phase frequency detector 130 detects a phase and a frequency of each of the reference clock output from the reference clock generation unit 420 and the feedback signal fed back from the voltage-controlled oscillator 190 to activate an up output (UP) when the phase difference is positive and activate a down output (DN) when the phase difference is negative.

The charge pump 150 outputs a loop current by performing charging and discharging according to the comparison signal output from the phase frequency detector 130. The charge pump 150 increases an output current by performing charging when the up input (UP) is activated, and decreases the output current by performing discharging when the down input (DN) is activated. The loop filter 170 filters the output of the charge pump 150 to generate a control voltage of the voltage-controlled oscillator 190. The voltage-controlled oscillator 190 is a known circuit which outputs a square wave having a frequency proportional to an input control voltage. Since detailed configurations and operations of these individual functional circuits are known in the field of phase locked loop circuits, detailed descriptions thereof will be omitted.

In one embodiment, the phase shift circuit may further include a controller 310. In the illustrated embodiment, the controller 310 determines an amount of phase shift and outputs a control signal according to the amount of phase shift. The controller 310 may have a form of an operation unit which outputs different resistance values as a user adjusts the controller 310 using a knob. As another example, the controller 310 may be implemented as a microprocessor which determines and outputs a phase adjustment current value to be transmitted to a target reception antenna in response to an external instruction. As still another example, the controller 310 may be implemented by some of the program instructions in an external controller. In a phase shift circuit having a fixed phase shift value, the controller 310 is not necessary.

An adjustment current generation unit 200 generates and outputs a phase shift value added to the adder circuit 410, that is, the phase adjustment current herein. In the illustrated embodiment, the adjustment current generation unit 200 is implemented as a digital-to-analog converter which converts a digital current value determined according to a phase adjustment amount and output from the controller 310 to an analog current value and outputs the analog current value. However, the present disclosure is not limited thereto, and the adjustment current generation unit 200 may be implemented as various circuits which output a digital control value of the controller 310, which may be output with various scales or offsets, as an analog current value capable of adjusting an offset of the phase locked loop circuit 100 of a specific structure. Further, when the phase locked loop circuit 100 is implemented as a digital circuit, the adjustment current generation unit 200 may simply be a digital circuit configured to output a digital value which represents a current value added according to an instruction of the controller 310. For example, the adjustment current generation unit 200 may be implemented as a memory having an input instruction value as an address input and a phase adjustment current value as a data output. As another example, in a phase shift circuit having a fixed phase shift value, the adjustment current generation unit 200 may be a constant current source which outputs a current having a predetermined magnitude.

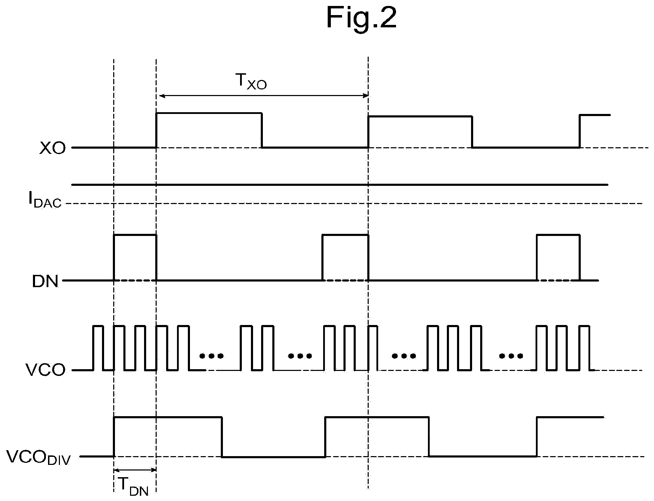

< Description in FIG. 2-operation of circuit of embodiment in FIG. 1>

FIG. 2 is an exemplary timing diagram between internal signals of the circuit in FIG. 1. As shown in the drawing, as a phase adjustment current $I_{DAC}$ is added to the output of the charge pump 150, an output VCO of the voltage-controlled oscillator 190 or an output $VCO_{DIV}$ of the feedback divider 120, which divides the output, has a phase difference $T_{DN}$ with an output XO of the reference clock generation unit 420. For ease of understanding, in the drawing, the phase difference $T_{DN}$ is exaggeratedly shown to cover a plurality of clocks, but actually, the phase difference $T_{DN}$ is more generally implemented as a phase shift within one clock range of the output VCO of the voltage-controlled oscillator 190. In this case, the output VCO of the voltage-controlled oscillator 190 and the output $VCO_{DIV}$ of the feedback divider 120, which divides the output, have the same phase difference as the output XO of the reference clock generation unit 420.

Unlike a common phase locked loop circuit, an output of the phase frequency detector 130 represents a phase difference caused by the phase adjustment current. In the illustrated timing example, a DN signal is output during a section in which a phase difference between the output XO of the reference clock generation unit 420 and the output $VCO_{DIV}$ of the feedback divider 120 is detected. The UP signal is activated in the case of a positive phase difference, and the DN signal is activated in the case of a negative phase difference.

In the phase locked loop circuit 100 in FIG. 1, since the total amount of charges introduced into the loop filter in a locked state should be 0, the following equation is satisfied. Here, a current $I_{CP}$ is a current value while the DN signal is activated.

$$(1) \qquad T_{XO} \times I_{DAC} = T_{DN} \times I_{CP}$$

Accordingly, when a division ratio of the feedback divider 120 is M, a phase shift of $T_{XO} \times I_{DAC} / I_{CP}$ (corresponding to M x $I_{DAC}$ / $I_{CP}$ x 360 degrees) occurs in a time domain in the phase shift circuit according to one embodiment of the present disclosure compared to a general phase locked loop circuit. The resolution of the phase shift of this circuit may be expressed as follows.

$$(2) \qquad I_{DAC, \text{ RESOLUTION}} = I_{CP} / M / 360$$

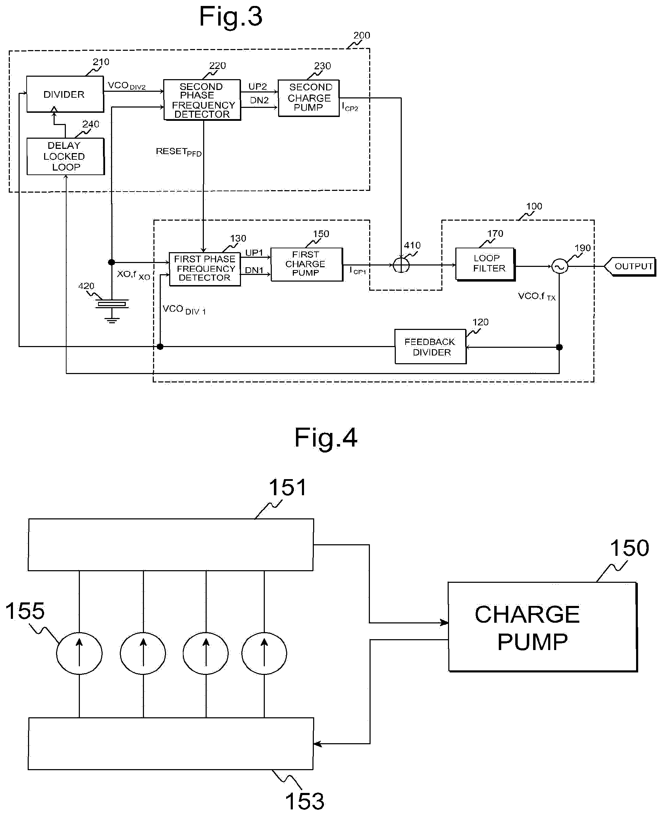

< Description of embodiment in FIG. 3-Description of invention of claim 1>

According to one aspect of the present disclosure, internal phase shifting is configured by adding a phase adjustment current to a loop current of a phase locked loop circuit of a wireless transmission terminal having a multi-array antenna. FIG. 3 is a block diagram illustrating a configuration of a phase shift circuit according to another embodiment to which this aspect is applied. Configurations similar to the embodiment of FIG. 1 are referred to by the same reference numerals. As shown in the drawing, the phase shift circuit according to another embodiment includes a phase locked loop circuit 100 and an adder circuit 410. The phase locked loop circuit 100 may be one of various types of generally known phase locked loop circuits. According to one aspect, the phase-locked loop circuit includes a feedback divider 120 in a feedback loop.

The adder circuit 410 adds the phase adjustment current to the loop current of the phase locked loop circuit 100. The adder circuit 410 may be implemented as an analog adder circuit when the phase locked loop circuit 100 is implemented as an analog circuit. As another example when the phase locked loop circuit 100 is implemented as a digital circuit, the adder circuit 410 may be implemented as a digital adder circuit.

Since an output frequency of the phase locked loop circuit 100 fluctuates as much as the phase adjustment current added by the adder circuit, and is fed back, a phase shift occurs. According to one aspect, since the phase adjustment current is applied to the adder circuit 410, this phase difference is maintained even when the feedback loop is in a stable state, and accordingly, an output of a voltage-controlled oscillator 190 has a phase difference with a reference frequency as intended by the phase adjustment current applied to the adder circuit.

In the illustrated embodiment, the phase locked loop circuit may include a first phase frequency detector (PFD) 130, a first charge pump 150, a loop filter 170, and the voltage-controlled oscillator 190. The first phase frequency detector 130 compares a phase difference between a reference clock output from a reference clock generation unit 420 and a feedback signal fed back from the voltage-controlled oscillator 190 to output a comparison signal. In the illustrated embodiment, the phase frequency detector 130 activates an up output (UP1) when the phase difference is positive and activates a down output (DN) when the phase difference is negative.

The first charge pump 150 performs charging and discharging according to an output of the first phase frequency detector 130. The first charge pump 150 increases an output current by performing charging when the up input (UP1) is activated, and decreases the output current by performing discharging when the down input (DN1) is activated. The loop filter 170 filters the output of the first charge pump 150 to generate a control voltage of the voltage-controlled oscillator 190. The voltage-controlled oscillator 190 is a known circuit which outputs a square wave having a frequency proportional to an input control voltage. Since detailed configurations and operations of these individual functional circuits are known in the field of phase locked loop circuits, detailed descriptions thereof will be omitted.

An adjustment current generation unit 200 generates and outputs a phase shift value added to the adder circuit 410, that is, the phase adjustment current herein. According to an additional aspect, the phase adjustment current may be generated by accumulating phase comparison signals between internal signals of the phase locked loop circuit and signals acquired by dividing or delaying the internal signals. In the illustrated embodiment, the adjustment current generation unit 200 includes a delay locked loop 240, a divider 210, a second phase frequency detector 220, and a second charge pump 230.

The delay locked loop 240 is a known circuit which includes a plurality of delay taps connected in series and sequentially delays and outputs reference clock signals input from the outside. An output of the voltage-controlled oscillator 190 is delayed in the delay locked loop 240 and then supplied to the divider 210. The divider 210 receives and divides an output of the feedback divider 120, and then outputs the output in synchronization with the output of the voltage-controlled oscillator delayed by the delay locked loop 240.

The second phase frequency detector 220 compares a phase between a reference clock output from a reference clock generation unit 420 and an output of the divider 210 to output a second comparison signal. In the illustrated embodiment, the second phase frequency detector 220 activates an up output (UP2) when the phase difference is positive, and activates a down output (DN2) when the phase difference is negative. Here, the first phase frequency detector 130 is reset with a reset signal $RESET_{PFD}$ output from the second phase frequency detector 220, and synchronized with the same reference clock XO.

The second charge pump 230 outputs a phase adjustment current as a phase adjustment signal by performing charging and discharging according to the second comparison signal that is an output of the second phase frequency detector 220. The second charge pump 230 increases an output current by performing charging when the up input (UP) is activated, and decreases the output current by performing discharging when the down input (DN) is activated.

Since the output of the divider 210 has a longer period than the output of the feedback divider 120, the output of the second phase frequency detector 220 may have a greater width than the output of the first phase frequency detector 130, and a phase adjustment current $I_{CP2}$ may have a wider fluctuation width than a loop current $I_{CP1}$ of the phase locked loop circuit 100. Since the delay locked loop 240 directly receives and delays the output of the voltage-controlled oscillator 190 without passing through the feedback divider 120, and thus synchronizes the output of the divider 210, the output of the second phase frequency detector 220 may be more precisely adjusted according to the configuration of the delay locked loop 240, which means that the resolution of the phase shift may be improved. From this description, it should be understood that the divider 210 and the delay locked loop 240 are independent components which do not need to be provided at the same time, and may be selectively combined.

In the embodiment shown in FIG. 1, matching circuits to make the degree of activation of the UP signal and the degree of activation of the DN signal the same to control the degree of phase adjustment in both directions is difficult because current sources in opposite directions should be matched. On the other hand, in the embodiment shown in FIG. 3, since only a ratio of the current $I_{CP1}$ and the current $I_{CP2}$ should be adjusted to control the degree of phase adjustment in both directions, controlling the degree of phase adjustment in both directions may be more easily achieved by matching the current sources in the same direction. For example, the degree of phase adjustment may be controlled in both directions by matching the DN signal of the first charge pump and the DN signal of the second charge pump. In this case, the UP signals do not require matching at all.

According to an additional aspect, one arbitrarily selected among a plurality of current sources may be connected to the charge pump so that the output current of the charge pump becomes constant on average. According to this aspect, the phase shift circuit according to one embodiment may include the plurality of current sources and a random charge/discharge switching unit. FIG. 4 illustrates one embodiment of a charge/discharge circuit of a charge pump to which this aspect is applied. Although the first charge pump 150 is shown and described as the shown charge/discharge circuit in FIG. 3, the same may be applied to the second charge pump 230, and preferably applied to both charge pumps at the same time.

As shown in the drawing, the charge/discharge circuit may include a plurality of current sources 155 and random charge/discharge switching units 151 and 153. The random charge/discharge switching units 151 and 153 connect one arbitrarily selected among the plurality of first current sources 155 to a charging input of the charge pump 150 according to the comparison signal output from the phase frequency detector. The random charge/discharge switching units 151 and 153 may include a random charge switching unit 151 and a random discharge switching unit 153. The random charge switching unit 151 connects one arbitrarily selected among the plurality of first current sources 155 to the charging input of the charge pump 150 when the comparison signal output from the phase frequency detector is the UP signal. The random discharge switching unit 153 connects one arbitrarily selected among the plurality of first current sources 155 to a discharging input of the charge pump 150 when the comparison signal output from the phase frequency detector is the DN signal. According to this structure, the output current of the charge pump is determined through a dynamic weight average method. The output of the charge pump is determined by one arbitrarily selected among a plurality of current sources connected in parallel without depending on one current source. Accordingly, stable locking can be achieved by reducing mismatches in the loop current of the phase locked loop circuit.

According to an additional aspect, the delay locked loop 240 may be a digital delay locked loop. The digital delay locked loop delays the output of the voltage-controlled oscillator according to a delay control word and supplies the output to a synchronization input of the divider 210. Korean Patent No. 744,069 filed on December 27, 2005 discloses a delay locked loop circuit using digital and analog control. As disclosed therein, when the delay locked loop circuit is implemented as a semiconductor integrated circuit, stable operation regardless of process, voltage, and temperature (PVT) fluctuations may be secured. A delay due to a receiver difference may be automatically controlled during a beamforming operation or a beam scanning operation using this structure.

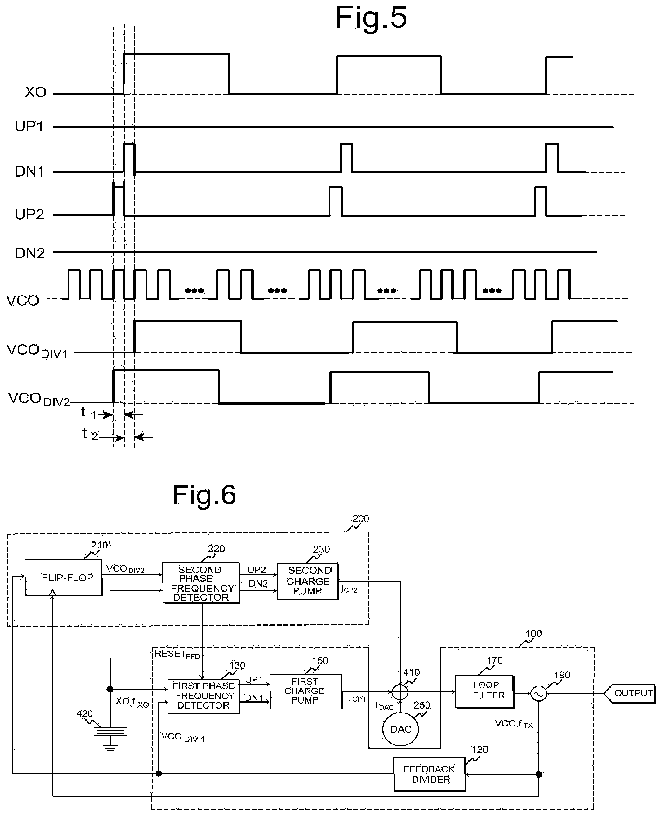

< Description in FIG. 5-operation of circuit of embodiment in FIG. 3>

FIG. 5 is an exemplary timing diagram between internal signals of the circuit in FIG. 3.

As shown in the drawing, as the phase adjustment current $I_{CP2}$ is added to the output of the charge pump 150, the output VCO of the voltage-controlled oscillator 190 or the output $VCO_{DIV1}$ of the feedback divider 120, which divides the output, has a phase difference $t_2$ with the output XO of the reference clock generation unit 420. Unlike a general phase locked loop circuit, the output of the phase frequency detector 130 represents the phase difference caused by the phase adjustment current. As shown in the exemplary drawing, the first phase frequency detector 130 outputs the comparison signal during a section in which a phase difference between the output XO of the reference clock generation unit 420 and the output $VCO_{DIV1}$ of the feedback divider 120 is detected. The UP1 signal is activated when the phase difference is a positive phase difference, and the DN1 signal is activated when the phase difference is a negative phase difference.

In the phase locked loop circuit 100 in FIG. 3, since the total amount of charges introduced into the loop filter 170 in a locked state should be 0, the following equations are satisfied in the timing diagram in FIG. 5. Here, the currents $I_{CP1}$ and $I_{CP2}$ are current values while the DN1 and DN2 signals are activated, respectively.

$$(3) \quad T_{DN1} \times I_{CP1} = T_{UP2} \times I_{CP2}$$

$$T_{VCO} = T_{DN1} + T_{UP2}$$

$$I_{CP} = I_{CP1} + I_{CP2}$$

$$t_1 : t_2 = I_{CP2} : I_{CP1}$$

Accordingly, when a division ratio of the feedback divider 120 is M, a phase shift of $I_{CP2} / (I_{CP1} + I_{CP2}) \times 360$

degrees occurs in the phase shift circuit according to another embodiment of the present disclosure compared to a general phase locked loop circuit. The resolution of the phase shift of this circuit may be expressed as follows.

$$(4) \qquad I_{CP, RESOLUTION} = I_{CP} / M / 360$$

Accordingly, the resolution of the phase shift may be improved compared to the embodiment in FIG. 1.

< Description of embodiment in FIG. 6-Description of invention of claim 7>

FIG. 6 is a block diagram illustrating a configuration of a phase shift circuit according to still another embodiment. The illustrated embodiment differs from the embodiment shown in FIG. 3 in that it further includes a digital-to-analog converter 250. The digital-to-analog converter 250 converts the control word output from the controller to an analog signal and supplies the analog signal as an additional phase adjustment signal to the adder circuit 410.

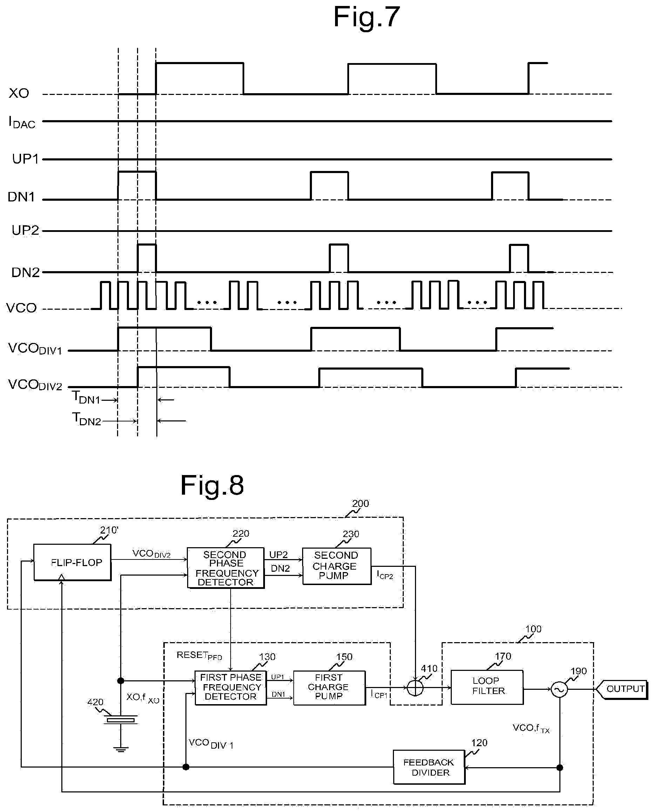

< Description in FIG. 7-operation of circuit of embodiment in FIG. 6>

FIG. 7 is an exemplary timing diagram between internal signals of the circuit in FIG. 6. As described above, in the phase locked loop circuit 100 in FIG. 6, since the total amount of charges introduced into the loop filter 170 in a locked state should be 0, the following equations are satisfied in the timing diagram in FIG. 7. Here, the currents $I_{CP1}$ and $I_{CP2}$ are current values while the DN1 and DN2 signals are activated, respectively.

$$(5) \qquad T_{DN1} \times I_{CP1} + T_{UP2} \times I_{CP2} = T_{XO} \times I_{DAC}$$

$$T_{VCO} = T_{DN1} - T_{DN2}$$

$$I_{CP} = I_{CP1} + I_{CP2}$$

Accordingly, when a division ratio of the feedback divider 120 is M, a phase shift of $((T_{XO} \times I_{DAC}) / (T_{VCO} \times I_{CP}) + I_{CP2} / I_{CP}) \times 360$ degrees occurs in the phase shift circuit according to the illustrated embodiment compared to a general phase locked loop circuit. When $(T_{XO} \times I_{DAC}) / (Tvco \times I_{CP})$ is fixed as a constant, $I_{CP, RESOLUTION} = I_{CP} / 360$ is necessary for acquiring a unit phase shift. This means that the same degree of phase shifting is achieved with a unit current M times greater and higher resolution is acquired than the above-described embodiments.

< Description of embodiment in FIG. 8-Description of invention of claim 8>

FIG. 8 is a block diagram illustrating a configuration of a phase shift circuit according to yet another embodiment. The embodiment in FIG. 8 is an embodiment in which the delay locked loop 240 has a delay amount of '0,' that is, is removed from the embodiment in FIG. 3, and thus the output of the voltage-controlled oscillator 190 is directly supplied without a delay, and the divider 210 is implemented as a flip-flop 210' having a division ratio of '1.' In the illustrated embodiment, the flip-flop 210' is a D-flip-flop. Accordingly, a detection signal output by the second phase frequency detector 220, which determines the phase adjustment signal $I_{CP2}$, is similar to a detection signal output by the first phase frequency detector 130, but may be clocked by the voltage-controlled oscillator 190 and may be adjusted with high resolution.

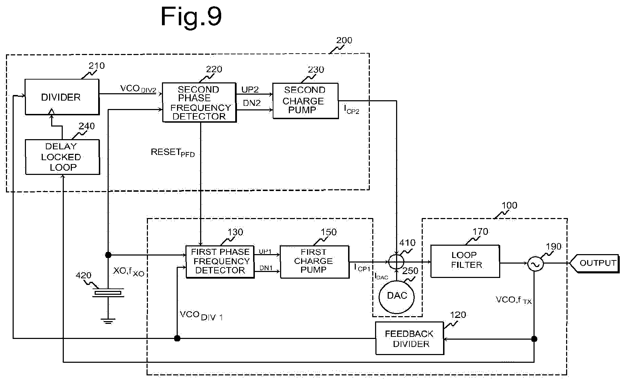

< Description of embodiment in FIG. 9-Description of invention of claim 9>

FIG. 9 is a block diagram illustrating a configuration of a phase shift circuit according to yet another embodiment. The embodiment in FIG. 9 differs from the embodiment shown in FIG. 8 in that it further includes a digital-to-analog converter 250. The digital-to-analog converter 250 converts the control word output from the controller to an analog signal and supplies the analog signal as an additional phase adjustment signal to the adder circuit 410. The embodiment in FIG. 9 is an embodiment in which the delay locked loop 240 has a delay amount of '0,' that is, is removed from the embodiment in FIG. 6, and thus the output of the voltage-controlled oscillator 190 is directly supplied without a delay, and the divider 210 is implemented as a flip-flop 210' having a division ratio of '1.' In the illustrated embodiment, the flip-flop 210' is a D-flip-flop.

According to the present disclosure, a phase shift function is realized by modifying a phase locked loop among existing circuits without adding a separate radio frequency (RF) phase shifter. Beamforming, which reduces signal mismatches in a reception antenna, is stable, and improves space efficiency, is achieved by avoiding path loss due to the addition of a separate phase shifter, and precisely controlling phase shifting without an error.

In the above, although the present disclosure has been described with reference to the accompanying drawings, the present disclosure is not limited thereto, and should be understood to encompass various modifications which may be clearly derived by those skilled in the art. For example, the phase locked loop circuit may be implemented as an all-digital phase locked loop (all-digital PLL) circuit. The claims are intended to encompass these modifications.

**Claims**

1.  A phase shift circuit comprising:

    a phase locked loop circuit (100) including:

    a feedback divider (120) in a feedback loop;
    a first phase frequency detector, PFD (130), configured to compare a phase between a reference clock (420) and an input frequency to output a first comparison signal;
    a first charge pump (150) configured to perform charging and discharging according to the first comparison signal to output a loop current;
    an adder circuit (410) configured to add a phase adjustment current to the loop current of the phase locked loop circuit (100);
    a a loop filter (170) configured to filter the loop loop current output by the adder circuit (410); and
    a voltage-controlled oscillator (190) configured to oscillate according to a loop filter output voltage,
    wherein the feedback divider (120) is configured to divide an output frequency of the voltage-controlled oscillator (190) to supply the divided output frequency as an input frequency to the first PFD (130); and

    an adjustment current generation unit (200) configured to generate the phase adjustment current signal and output the phase adjustment current signal to the adder circuit (410),
    wherein the adjustment current generation unit (200) includes:

    a divider (210) configured to receive an output of the feedback divider (120) and synchronize the output with an output of the voltage-controlled oscillator (190) to output a synchronized output;
    a second phase frequency detector, PFD (220), configured to compare a phase between the reference clock (420) and the output of the divider (210) to output a second comparison signal; and
    a second charge pump (230) configured to perform charging and discharging according to the second comparison signal to output the phase adjustment current.

2.  The phase shift circuit of claim 1, wherein the adjustment current generation unit (200) is further configured to output a phase adjustment current signal from a control word output from a controller (310).

3.  The phase shift circuit of claim 2, wherein the adjustment current generation unit (200) is a digital-to-analog converter configured to convert the control word output from the controller (310) to an analog signal and output the analog signal as the phase adjustment current signal.

4.  The phase shift circuit of claim 1, further comprising:

    a first random charge/discharge switching unit (151) configured to connect a plurality of first current sources (155) and one arbitrarily selected among the plurality of first current sources (155) according to the first comparison signal to a charge/discharge input of the first charge pump (150); and
    a second random charge/discharge switching unit (153) configured to connect a plurality of second current sources (155) and one arbitrarily selected among the plurality of second current sources (155) according to the second comparison signal to a charge/discharge input of the second charge pump (230).

5.  The phase shift circuit of claim 1, further comprising a delay locked loop (240) configured to delay the output of the voltage-controlled oscillator (190) to supply the output as a synchronization input of the divider (210).

6.  The phase shift circuit of claim 5, wherein the delay locked loop (240) is a digital delay locked loop configured to delay the output of the voltage-controlled oscillator (190) according to a delay control word to supply the output as the synchronization input of the divider (210).

7.  The phase shift circuit of claim 4, further comprising a digital-to-analog converter (250) configured to convert a control word output from a controller (310) to an analog signal, and supply the analog signal as an additional phase adjustment signal to the adder circuit (410).

8. A phase shift circuit comprising:

a phase locked loop circuit (100) including:

a feedback divider (120) in a feedback loop;
a first phase frequency detector, PFD (130), configured to compare a phase between a reference clock (420) and an input frequency to output a first comparison signal;
a first charge pump (150) configured to perform charging and discharging according to the first comparison signal to output a loop current;

an adder circuit (410) configured to add a phase adjustment current to the loop current of the phase locked loop circuit (100);

a loop filter (170) configured to filter the loop current output by the adder circuit (410); and
a voltage-controlled oscillator (190) configured to oscillate according to a loop filter output voltage,
wherein the feedback divider (120) is configured to divide an output frequency of the voltage-controlled oscillator (190) to supply the divided output frequency as an input frequency to the first PFD (130); and

an adjustment current generation unit (200) configured to generate the phase adjustment current signal and output the phase adjustment current signal to the adder circuit (410),
wherein the adjustment current generation unit (200) includes:

a flip-flop (210') configured to receive an output of the feedback divider (120) and synchronize the output with an output of the voltage-controlled oscillator (190) to output a synchronized output;
a second phase frequency detector, PFD (220), configured to compare a phase between the reference clock (420) and the output of the flip-flop (210') to output a second comparison signal; and
a second charge pump (230) configured to perform charging and discharging according to the second comparison signal to output the phase adjustment current.

9. The phase shift circuit of claim 8, further comprising a digital-to-analog converter (250) configured to convert a control word output from a controller (310) to an analog signal, and supply the analog signal as an additional phase adjustment current signal to the adder circuit (410).

10. A wireless transmission device comprising:

the phase shift circuit according to claim 1 or to claim 8;
a modulator configured to modulate input data with a signal phase shifted in the phase shift circuit;
a power amplifier configured to amplify an output of the modulator; and
an antenna configured to wirelessly transmit an output of the power amplifier.

**Patentansprüche**

1. Eine Phasenverschiebungsschaltung aufweisend:
eine Schaltung mit Phasenregelkreis (100), die aufweist:

einen Rückkopplungsteiler (120) in einer Rückkopplungsschleife;
einen ersten Phasenfrequenzdetektor, PFD (130), der so konfiguriert ist, dass er eine Phase zwischen einem Referenztakt (420) und einer Eingangsfrequenz vergleicht, um ein erstes Vergleichssignal auszugeben;
eine erste Ladungspumpe (150), die so konfiguriert ist, dass sie ein Laden und Entladen gemäß dem ersten Vergleichssignal durchführt, um einen Schleifenstrom auszugeben;
eine Addiererschaltung (410), die so konfiguriert ist, dass sie einen Phaseneinstellstrom zu dem Schleifenstrom der Phasenregelkreisschaltung (100) addiert;
einen Schleifenfilter (170), der zum Filtern des von der Addiererschaltung (410) ausgegebenen Schleifenstroms konfiguriert ist; und

einen spannungsgesteuerten Oszillator (190), der so konfiguriert ist, dass er entsprechend einer Ausgangsspannung des Schleifenfilters schwingt,

wobei der Rückkopplungsteiler (120) so konfiguriert ist, dass er eine Ausgangsfrequenz des spannungsgesteuerten Oszillators (190) teilt, um die geteilte Ausgangsfrequenz als eine Eingangsfrequenz an den ersten PFD (130) zu liefern; und

eine Einstellstromerzeugungseinheit (200), die zum Erzeugen des Phaseneinstellstromsignals und zum Ausgeben des Phaseneinstellstromsignals an die Addiererschaltung (410) konfiguriert ist,

wobei die Einstellstromerzeugungseinheit (200) aufweist:

einen Rückkopplungsteiler (210), der so konfiguriert ist, dass er einen Ausgang des Rückkopplungsteilers (120) empfängt und den Ausgang mit einem Ausgang des spannungsgesteuerten Oszillators (190) synchronisiert, um einen synchronisierten Ausgang auszugeben;

einen zweiten Phasenfrequenzdetektor, PFD (220), der so konfiguriert ist, dass er eine Phase zwischen dem Referenztakt (420) und dem Ausgang des Teilers (210) vergleicht, um ein zweites Vergleichssignal auszugeben; und

eine zweite Ladungspumpe (230), die so konfiguriert ist, dass sie ein Laden und Entladen gemäß dem zweiten Vergleichssignal durchführt, um den Phaseneinstellstrom auszugeben.

2. Die Phasenverschiebungsschaltung nach Anspruch 1, wobei die Anpassungsstrom-Erzeugungseinheit (200) weiter konfiguriert ist, um ein Phasenanpassungsstromsignal von einem Steuerwort auszugeben, das von einer Steuereinheit (310) ausgegeben wird.

3. Die Phasenverschiebungsschaltung nach Anspruch 2, wobei die Einstellstromerzeugungseinheit (200) ein Digital-Analog-Wandler ist, der so konfiguriert ist, dass er das von der Steuereinheit (310) ausgegebene Steuerwort in ein analoges Signal umwandelt und das analoge Signal als das Phaseneinstellstromsignal ausgibt.

4. Die Phasenverschiebungsschaltung nach Anspruch 1, die ferner aufweist:

eine erste zufällige Lade/Entlade-Schalteinheit (151), die so konfiguriert ist, dass sie eine Vielzahl von ersten Stromquellen (155) und eine aus der Vielzahl von ersten Stromquellen (155) gemäß dem ersten Vergleichssignal willkürlich ausgewählte Stromquelle mit einem Lade/Entlade-Eingang der ersten Ladungspumpe (150) verbindet; und

eine zweite zufällige Lade/Entlade-Schalteinheit (153), die so konfiguriert ist, dass sie eine Vielzahl von zweiten Stromquellen (155) und eine willkürlich aus der Vielzahl von zweiten Stromquellen (155) gemäß dem zweiten Vergleichssignal ausgewählte mit einem Lade/Entlade-Eingang der zweiten Ladungspumpe (230) verbindet.

5. Die Phasenverschiebungsschaltung nach Anspruch 1 weist ferner eine Verzögerungsregelschleife (240) auf, die so konfiguriert ist, dass sie den Ausgang des spannungsgesteuerten Oszillators (190) verzögert, um den Ausgang als Synchronisationseingang des Teilers (210) zu liefern.

6. Die Phasenverschiebungsschaltung nach Anspruch 5, wobei die Verzögerungsregelschleife (240) eine digitale Verzögerungsregelschleife ist, die so konfiguriert ist, dass sie den Ausgang des spannungsgesteuerten Oszillators (190) entsprechend einem Verzögerungssteuerwort verzögert, um den Ausgang als Synchronisationseingang des Teilers (210) zu liefern.

7. Die Phasenverschiebungsschaltung nach Anspruch 4 weist ferner einen Digital-Analog-Wandler (250) auf, der so konfiguriert ist, dass er ein von einer Steuereinheit (310) ausgegebenes Steuerwort in ein Analogsignal umwandelt und das Analogsignal als zusätzliches Phaseneinstellsignal an die Addiererschaltung (410) liefert.

8. Eine Phasenverschiebungsschaltung aufweisend:
eine Phasenregelkreis-Schaltung (100), die aufweist:

einen Rückkopplungsteiler (120) in einer Rückkopplungsschleife;

einen ersten Phasenfrequenzdetektor, PFD (130), der so konfiguriert ist, dass er eine Phase zwischen einem Referenztakt (420) und einer Eingangsfrequenz vergleicht, um ein erstes Vergleichssignal auszugeben;

eine erste Ladungspumpe (150), die so konfiguriert ist, dass sie ein Laden und Entladen entsprechend dem ersten Vergleichssignal durchführt, um einen Schleifenstrom auszugeben; eine Addiererschaltung (410), die so konfiguriert ist, dass sie einen Phaseneinstellstrom zu dem Schleifenstrom der Phasenregelkreisschaltung (100) addiert;

einen Schleifenfilter (170), der zum Filtern des von der Addiererschaltung (410) ausgegebenen Schleifenstroms konfiguriert ist; und

einen spannungsgesteuerten Oszillator (190), der so konfiguriert ist, dass er entsprechend einer Ausgangsspannung des Schleifenfilters schwingt,

wobei der Rückkopplungsteiler (120) so konfiguriert ist, dass er eine Ausgangsfrequenz des spannungsgesteuerten Oszillators (190) teilt, um die geteilte Ausgangsfrequenz als eine Eingangsfrequenz dem ersten PFD (130) zuzuführen; und

eine Einstellstromerzeugungseinheit (200), die zum Erzeugen des Phaseneinstellstromsignals und zum Ausgeben des Phaseneinstellstromsignals an die Addiererschaltung (410) konfiguriert ist,

wobei die Einstellstromerzeugungseinheit (200) folgendes aufweist:

ein Flip-Flop (210'), das so konfiguriert ist, dass es einen Ausgang des Rückkopplungsteilers (120) empfängt und den Ausgang mit einem Ausgang des spannungsgesteuerten Oszillators (190) synchronisiert, um einen synchronisierten Ausgang auszugeben

einen zweiten Phasenfrequenzdetektor, PFD (220), der so konfiguriert ist, dass er eine Phase zwischen dem Referenztakt (420) und dem Ausgang des Flipflops (210') vergleicht, um ein zweites Vergleichssignal auszugeben; und

eine zweite Ladungspumpe (230), die so konfiguriert ist, dass sie ein Laden und Entladen gemäß dem zweiten Vergleichssignal durchführt, um den Phaseneinstellstrom auszugeben.

9. Die Phasenverschiebungsschaltung nach Anspruch 8 weist ferner einen Digital-Analog-Wandler (250) auf, der so konfiguriert ist, dass er ein von einer Steuereinheit (310) ausgegebenes Steuerwort in ein analoges Signal umwandelt und das analoge Signal als ein zusätzliches Phaseneinstellstromsignal an die Addiererschaltung (410) liefert.

10. Eine drahtlose Übertragungsvorrichtung, die aufweist:

die Phasenverschiebungsschaltung nach Anspruch 1 oder nach Anspruch 8;

einen Modulator, der so konfiguriert ist, dass er Eingangsdaten mit einem in der Phasenverschiebungsschaltung phasenverschobenen Signal moduliert;

einen Leistungsverstärker, der so konfiguriert ist, dass er einen Ausgang des Modulators verstärkt; und

eine Antenne, die so konfiguriert ist, dass sie ein Ausgangssignal des Leistungsverstärkers drahtlos überträgt.

**Revendications**

1. Circuit de déphasage comprenant :

un circuit à boucle à verrouillage de phase (100) incluant :

un diviseur de rétroaction (120) dans une boucle de rétroaction ;

un premier détecteur de fréquence de phase, PFD (130), configuré pour comparer une phase entre une horloge de référence (420) et une fréquence d'entrée pour émettre un premier signal de comparaison ;

une première pompe de charge (150) configurée pour effectuer une charge et une décharge selon le premier signal de comparaison pour émettre un courant de boucle ;

un circuit additionneur (410) configuré pour ajouter un courant d'ajustement de phase au courant de boucle du circuit à boucle à verrouillage de phase (100) ;

un filtre de boucle (170) configuré pour filtrer le courant de boucle produit par le circuit additionneur (410) ; et

un oscillateur commandé en tension (190) configuré pour osciller selon une tension de sortie du filtre de boucle,

dans lequel le diviseur de rétroaction (120) est configuré pour diviser une fréquence de sortie de l'oscillateur commandé en tension (190) pour fournir la fréquence de sortie divisée en tant que fréquence d'entrée au premier PFD (130) ;

une unité de génération de courant d'ajustement (200) configurée pour générer le signal de courant d'ajustement de phase et émettre le signal de courant d'ajustement de phase au circuit additionneur (410),

dans lequel l'unité de génération de courant d'ajustement (200) inclut :

un diviseur (210) configuré pour recevoir une sortie du diviseur de rétroaction (120) et synchroniser la sortie avec une sortie de l'oscillateur commandé en tension (190) pour émettre une sortie synchronisée ;

un deuxième détecteur de fréquence de phase, PFD (220), configuré pour comparer une phase entre l'horloge de référence (420) et la sortie du diviseur (210) pour émettre un deuxième signal de comparaison ; et

une deuxième pompe de charge (230) configurée pour effectuer une charge et une décharge selon le deuxième signal de comparaison pour émettre le courant d'ajustement de phase.

2. Circuit de déphasage selon la revendication 1, dans lequel l'unité de génération de courant d'ajustement (200) est en outre configurée pour émettre un signal de courant d'ajustement de phase à partir d'un mot de commande émis par un contrôleur (310).

3. Circuit de déphasage selon la revendication 2, dans lequel l'unité de génération de courant d'ajustement (200) est un convertisseur numériqueanalogique configuré pour convertir le mot de commande émis par le contrôleur (310) en un signal analogique et émettre le signal analogique en tant que signal de courant d'ajustement de phase.

4. Circuit de déphasage selon la revendication 1, comprenant en outre :

une première unité de commutation de charge/décharge aléatoire (151) configurée pour connecter une pluralité de premières sources de courant (155) et une source arbitrairement sélectionnée parmi la pluralité de premières sources de courant (155) selon le premier signal de comparaison à une entrée de charge/décharge de la première pompe de charge (150) ; et

une deuxième unité de commutation de charge/décharge aléatoire (153) configurée pour connecter une pluralité de deuxièmes sources de courant (155) et une sélectionnée arbitrairement parmi la pluralité de deuxièmes sources de courant (155) selon le deuxième signal de comparaison à une entrée de charge/décharge de la deuxième pompe de charge (230).

5. Circuit de déphasage selon la revendication 1, comprenant en outre une boucle à verrouillage de retard (240) configurée pour retarder la sortie de l'oscillateur commandé en tension (190) pour fournir la sortie comme entrée de synchronisation du diviseur (210).

6. Circuit de déphasage selon la revendication 5, dans lequel la boucle à verrouillage de retard (240) est une boucle à verrouillage de retard numérique configurée pour retarder la sortie de l'oscillateur commandé en tension (190) selon un mot de commande de retard pour fournir la sortie en tant qu'entrée de synchronisation du diviseur (210).

7. Circuit de déphasage selon la revendication 4, comprenant en outre un convertisseur numériqueanalogique (250) configuré pour convertir un mot de commande en sortie d'un contrôleur (310) en un signal analogique, et fournir le signal analogique en tant que signal d'ajustement de phase supplémentaire au circuit additionneur (410).

8. Circuit de déphasage comprenant :

un circuit à boucle à verrouillage de phase (100) incluant :

un diviseur de rétroaction (120) dans une boucle de rétroaction ;

un premier détecteur de fréquence de phase, PFD (130), configuré pour comparer une phase entre une horloge de référence (420) et une fréquence d'entrée pour émettre un premier signal de comparaison ;

une première pompe de charge (150) configurée pour effectuer une charge et une décharge selon le premier signal de comparaison pour émettre un courant de boucle ;

un circuit additionneur (410) configuré pour ajouter un courant d'ajustement de phase au courant de boucle du circuit à boucle à verrouillage de phase (100) ;

un filtre de boucle (170) configuré pour filtrer le courant de boucle produit par le circuit additionneur (410) ; et

un oscillateur commandé en tension (190) configuré pour osciller selon une tension de sortie du filtre de boucle,

dans lequel le diviseur de rétroaction (120) est configuré pour diviser une fréquence de sortie de l'oscillateur commandé en tension (190) pour fournir la fréquence de sortie divisée en tant que fréquence d'entrée au premier PFD (130) ; et

une unité de génération de courant d'ajustement (200) configurée pour générer le signal de courant d'ajustement de phase et émettre le signal de courant d'ajustement de phase vers le circuit additionneur (410), dans lequel l'unité de génération de courant d'ajustement (200) inclut :

une bascule (210') configurée pour recevoir une sortie du diviseur de rétroaction (120) et synchroniser la sortie avec une sortie de l'oscillateur commandé en tension (190) pour émettre une sortie synchronisée ; un deuxième détecteur de fréquence de phase, PFD (220), configuré pour comparer une phase entre l'horloge de référence (420) et la sortie de la bascule (210') pour émettre un deuxième signal de comparaison ; et une deuxième pompe de charge (230) configurée pour effectuer une charge et une décharge selon le deuxième signal de comparaison pour émettre le courant d'ajustement de phase.

9. Circuit de déphasage selon la revendication 8 comprenant en outre un convertisseur numériqueanalogique (250) configuré pour convertir un mot de commande en sortie d'un contrôleur (310) en un signal analogique, et fournir le signal analogique en tant que signal de courant d'ajustement de phase supplémentaire au circuit additionneur (410).

10. Dispositif de transmission sans fil comprenant :

le circuit de déphasage selon la revendication 1 ou la revendication 8 ; un modulateur configuré pour moduler des données d'entrée avec un signal déphasé dans le circuit de déphasage ; un amplificateur de puissance configuré pour amplifier une sortie du modulateur ; et une antenne configurée pour transmettre sans fil une sortie de l'amplificateur de puissance.

# Fig.1

# Fig.2

# Fig.3

# Fig.4

# Fig.5

# Fig.6

# Fig.7

# Fig.8

Fig.9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6317476 B1
- US 2011012683 A1
- US 2001007436 A1
- KR 744069

### Non-patent literature cited in the description

- A 60 GHz receiver front-end with PLL based phase controlled LO generation for phased-arrays. **AXHOLT ANDREAS et al.** Analog Integrated Circuits And Signal Processing. Springer, 29 April 2014, 23-32
- A PLL based 12GHz LO generator with digital phase control in 90nm CMOS. **AXHOLT A et al.** Microwave Conference, 2009. APMC 2009. IEEE, 07 December 2009, 289-292